Europäisches Patentamt

European Patent Office

Office européen des brevets

(19)

(11) **EP 0 751 623 A1**

(12) **EUROPEAN PATENT APPLICATION**

(43) Date of publication:
02.01.1997 Bulletin 1997/01

(51) Int. Cl.$^6$: **H03K 17/95**

(21) Application number: **95110234.2**

(22) Date of filing: **30.06.1995**

(84) Designated Contracting States:
AT BE CH DE DK ES FR GB GR IE IT LI LU MC NL PT SE

(71) Applicant: **Carlo Gavazzi AG**
**CH-6312 Steinhausen (CH)**

(72) Inventor: **Brorsen, Hans,**
c/o Carlo Gavazzi AG
CH-6312 Steinhausen (CH)

(74) Representative: **Kehl, Günther, Dipl.-Phys. et al**
**Patentanwälte**
**Hagemann & Kehl**
**Postfach 86 03 29**
**81630 München (DE)**

(54) **Inductive proximity sensor**

(57) Inductive proximity sensor comprising a resonance circuit including a coil (1) and further comprising a signal processing circuit (3) electrically connected to said resonance circuit. Said coil (1) consists of at least one conductive layer printed or vapour-deposited on a section of a sheet of isolating material (2) such as a printed circum 7 board around a centre portion thereof. Said section of said sheet of isolating (2) material is partially surrounded by a ferrite core (4). Said ferrite core comprises a rear wall (5) parallel to the plane of said sheet of isolating material (2), and at least one circumferential wall portion (6a, 6b) surrounding said at least one conductive layer around its outer edge and extending in perpendicular direction to the plane of the sheet of isolating material (2).

The ferrite core (4) may comprise a central ferrite core-part (7) projecting perpendicularly from said rear wall (5) and protruding through said centre portion of said sheet of isolating material (2).

Fig.1

EP 0 751 623 A1

## Description

The present invention generally relates to the field of electronic sensors, switches, or transducers. In particular, the present invention relates to a sensor using the inductive measuring principle, a so called inductive sensor comprising a resonance circuit including a coil and further comprising a signal processing circuit electrically connected to said resonance circuit.

Electronic sensors of the prior art are commonly implanted in electric control circuits or electric regulator circuits. Unlike mechanically manipulated electric sensors, they are realized in a non-contacting way. This is especially true for so called inductive proximity switches which nowadays work without exception in a contactless manner.

Such inductive proximity switches are used to detect if an object, for which the corresponding inductive proximity switch is sensitive for, has approached the inductive proximity switch and has entered the sensing range of the proximity switch. In such a case the proximity switch is activated, indicating the presence of the object. Inductive proximity switches normally include an oscillator circuit which is inductively controlled. The operation of this oscillator circuit can be described by the product $f \cdot A$, where $f$ is the feedback factor and $A$ is the loop gain factor. As long as a certain object approaching the coil of the inductive sensor has not come sufficiently close to the sensor the relation $f \cdot A > 1$ is valid for the oscillator circuit, i.e. the oscillator is in oscillating condition. With the object reaching the predetermined sensing distance from the inductive proximity switch the increasing attenuation of the oscillator results in a decrease of the gain $A$ so that the product $f \cdot A$ becomes $< 1$, i.e. the amplitude of the oscillation decreases and finally the oscillation stops. This status of the vanishing oscillation is detected by the signal processing circuit which is electrically connected to said resonance circuit and a signal for making or breaking a contact is derived from that.

An inductive proximity switch according to the above mentioned principle is known from German Patent DE 32 44 449 C2. Although this document proposes to provide an auxiliary coil which may consist of a pattern printed on a printed circuit board, the main coil of this proximity switch consists of a wire wound around a coil former.

The production of proximity switches of that kind is labour intensive because different components such as coils and coil formers must be handled and different kinds of half fabrications must be assembled. The provision of a coil consisting of wires wound around a coil former requires much space and does therefore not allow miniaturization of the sensor.

In consideration of the problems described above, it is an object of the present invention to provide an inductive proximity sensor which can be produced in a labour saving manner and which lends itself to the production of more flat articles.

This object is achieved by an inductive proximity sensor according to claim 1.

The ferrite core serves to focus a magnetic field to be detected and thus increases the sensitivity of the sensor.

In another preferred embodiment of the present invention said conductive layers are printed according to the thick-film-technology. This means that the conductive layers are printed onto the sheet of isolating material by silk-screen printing. The thickness of the layers is normally greater than 10 $\mu$m. By using the silk-screen printing method sufficiently fine structures of coil windings can be produced.

According to another embodiment of the present invention the conductive layers are deposited according to thin-film-technology. According to this method the conductive layers forming the coil of the proximity sensor are produced under vacuum by metallic vapour deposition or cathode-sputtering. The thickness of the layers is usually less than 10 $\mu$m. The pattern of the coil windings can be realized by providing a metallic mask or a mask of oxide.

The coil windings can be made in one single layer or according to another embodiment of several layers, which are deposited onto the sheet of isolating material. This can be advantageously a printed circuit board. The printed circuit board may contain - preferably at its rear side - the electronic part of the signal processing circuit. So the product can be made very compact so that it lends itself to miniaturisation.

In order to adjust the sensitivity range of the inductive proximity sensor according to the invention the sheet of isolating material can be made adjustable within said ferrite core. So if the sheet of isolating material or printed circuit board having the printed coil windings on it, is placed close to the open side of the housing this results in a longer distance of the sensitivity limit. On the other hand in such a case the inductive proximity sensor is more sensitive to surrounding metals. If on the other hand the sheet of isolating material having the coil windings on it is placed further inside the ferrite core, i.e. close to the rear wall, this results in a shorter distance of the sensitivity threshold, i.e. an object can only be detected if it approaches the proximity sensor close. However, in such a case the inductive proximity sensor is less sensitive to surrounding metals.

According to a particularly advantageous embodiment of the present invention the sheet of isolating material having the coil windings on it is situated entirely within said circumferential wall of said ferrite core. So the sheet of isolating material, which has the form of a ring, may be surrounded by the ferrite core.

However, it lies also within the scope of the invention to provide a sensor having a sheet of isolating material, especially a printed circuit board (= PCB), which extends laterally beyond said ferrite core and has openings through which said ferrite core protrudes.

The present invention will be described in more detail below with reference to the exemplary embodiments which are schematically illustrated in the following drawings in which:

Figure 1: is a plan view of an inductive proximity sensor according to a first embodiment of the invention.

Figure 2: is a section according to line II-II in figure 1.

Figure 3: is a sectional view of a second embodiment of the invention.

Figure 4: is a plan view of a printed circuit board with components and coil, without ferrite core according to a third embodiment.

Figure 5: is a plan view of the third embodiment of an inductive proximity sensor according to the invention and

Figure 6: is a section according to line VI-VI of figure 5.

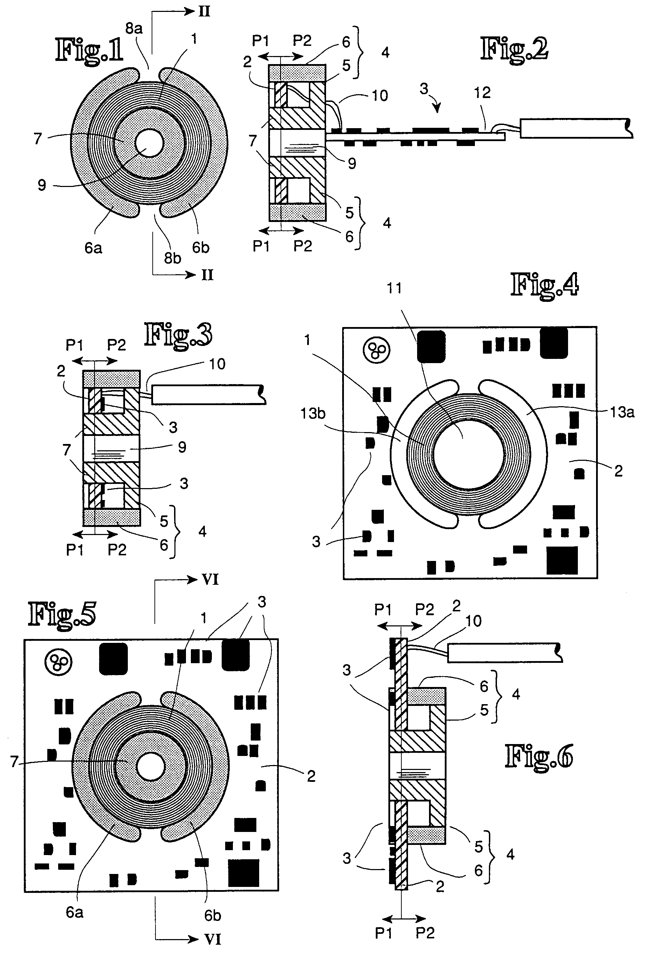

In the plan view of figure 1 reference numeral 1 designates a coil consisting of several windings printed on a printed circuit board (= PCB). The printed circuit board which is covered by the windings of coil 1 has the shape of a ring. It is provided with a ferrite core 4, having circumferential wall portions 6a and 6b surrounding the coil 1. The circumferential wall portion 6a and 6b form a cylinder which has two longitudinal slots 8a and 8b which separate the two circumferential wall portions 6a and 6b. A centre part 7 of the ferrite core 4 protrudes through the centre of the ring shaped coil 1. The centre part 7 of the ferrite core 4 has itself a longitudinal central bore so that it is also ring-shaped in cross section.

As can be seen from the axial section of figure 2 the circumferential wall portions 6a and 6b which form the circumferential wall 6 are connected to a rear wall 5.

Figure 2 shows also the centre part 7 of the ferrite core 4 which extends from the centre of the rear wall 5. The centre part 7 of the ferrite core 4 has a longitudinal central bore 9 in it. The centre part 7 and the circumferential wall 6, consisting of two circumferential wall portions 6a and 6b, define a ring space which is closed at one side by rear wall 5. In this ring space there is located a ring-shaped sheet of isolating material 2, such as a printed circuit board. The sheet of isolating material 2 carries on its side facing the open part of the ferrite core 4 a coil 1 consisting of conductive layers printed on the sheet of isolating material 2. It is also possible to arrange the coil 1 on the side facing the rear wall 5 or on both sides.

A further printed circuit board 12 carrying electronic components of the signal processing circuit 3 is attached to the rear wall 5 of the ferrite core and extends in longitudinal direction from the ferrite core 4. The signal processing circuit 3 is connected by a pair of wires 10 to the coil 1.

The position of the sheet of isolating material 2 can be adjusted inside the ferrite core 4 in axial direction by shifting the sheet of isolating material 2 in the direction of the arrow P1 or the arrow P2. If the sheet of isolating material 2 is located close to the open side of the ferrite core 4 the inductive proximity sensor has a larger sensitivity range, i.e. an object approaching the sensor can be detected already at relative large distances. However, in such a case the proximity sensor is more sensitive for surrounding metals.

If the sheet of isolating material 2 is shifted in the direction of arrow P2, i.e. if it is placed close to the rear wall 5 of the ferrite core 4, the sensitivity range of the sensor is reduced. This means, an object must approach the sensor relatively close in order to be detected. However, in this case the sensor is less sensitive to surrounding metals.

Figures 3 shows a second embodiment. The ferrite core 4 consisting of rear wall 5, circumferential wall portions 6a and 6b and centre part 7 is the same as that of the embodiment of figures 1 and 2. Therefor the plan view of the second embodiment is the same as shown in figure 1. However, the printed circuit board 2, which carries the printed coil windings 1 on its front side carries on its rear side the electronic parts of the signal processing circuit 3. So there is no additional printed circuit board such as part 12 shown in figure 2. The signal processing circuit 3 is connected via a pair of wires 10 directly to an output terminal.

Figures 4, 5 and 6 show a third embodiment of the invention. Also in this embodiment of the invention the ferrite core 7 is used in the same way as described before with regard to the first and second embodiment. However, the printed circuit board 2 is not ring-shaped as in the embodiments of figures 1 through 3 but has a square form which is larger than the area of the ferrite core 4. Figure 4 shows the printed circuit board 2 with the printed coil 1 and the electronic parts 3, which form the signal processing circuit 3, mounted on it.

The printed circuit board 2 has a central circular opening 11 which is formed so as to receive centre part 7 of the ferrite core 4. There are provided two further openings 13a and 13b which are designed to snuggly receive the circumferential wall portions 6a and 6b of the ferrite core 4.

Figure 5 shows the plan view of the inductive proximity sensor according to the third embodiment whereby the ferrite core 4 including the wall portions 6a and 6b is inserted into the printed circuit board 2.

Figure 6 is a sectional view showing the ferrite core 4 and the printed circuit board 2 with the electronic parts of the signal processing circuit 3. The wall portions 6a and 6b of the ferrite core 4 protrude through openings (openings 13a and 13b in figure 4) in the printed circuit board 2. The part of the printed circuit board 2 which lies inside the circumferential wall portions 6a and 6b carries the coil 1 as in the previously described embodiments. The part of the printed circuit board 2 which extends laterally beyond the circumferential wall 6 carries the electronic parts of the signal processing circuit 3. The signal processing circuit 3 is connected to an output terminal via a pair of wires 10.

Also in this embodiment the position of the printed circuit board 2 relative to the housing 4 can be adjusted in the direction of the arrows P1 and P2 respectively with the same result as mentioned above.

**Claims**

1. Inductive proximity sensor comprising a resonance circuit including a coil (1) and further comprising a signal processing circuit (3) electrically connected to said resonance circuit, **characterized** by said coil (1) consisting of at least one conductive layer printed or vapour-deposited on a section of a sheet of isolating material (2) around a centre portion thereof, said section of said sheet of isolating (2) material being partially surrounded by a ferrite core (4), said ferrite core comprising a rear wall (5) parallel to the plane of said sheet of isolating material (2), and at least one circumferential wall portion (6a, 6b) surrounding said at least one conductive layer around its outer edge and extending in perpendicular direction to the plane of the sheet of isolating material (2).

2. Inductive proximity sensor according to claim 1, wherein said ferrite core (4) comprises a center part (7) projecting perpendicularly from said rear wall (5) and protruding through said centre portion of said sheet of isolating material (2).

3. Inductive proximity sensor according to claim 1 or 2, wherein said at least one conductive layer is printed according to the thick-film-technology.

4. Inductive proximity sensor according to claim 1 or 2, wherein said at least one conductive layer is deposited according to the thin-film-technology.

5. Inductive proximity sensor according to any of the preceding claims, wherein the coil (1) consists of one single layer.

6. Inductive proximity sensor according to any of claims 1-4, wherein the coil (1) consists of several layers.

7. Inductive proximity sensor according to any of the preceding claims, wherein said sheet of isolating material (2) is a printed circuit board.

8. Inductive proximity sensor according to claim 7, wherein said printed circuit board comprises said signal processing circuit (3) in addition to said coil.

9. Inductive proximity sensor according to any of the preceding claims, wherein said sheet of isolating material (2) is moveable in a direction perpendicular to the plane of said rear wall (5) so that its position is adjustable within said ferrite core (4).

10. Inductive proximity sensor according to any of the preceding claims, wherein said sheet of isolating material (2) is situated entirely within said at least one circumferential wall portion (6a, 6b) of said ferrite core (4).

11. Inductive proximity sensor according to any of claims 1 - 9, wherein said sheet of isolating material (2) extends laterally beyond said at least one circumferential wall portion (6a, 6b) of said ferrite core (4) and has openings through which said at least one circumferential wall portion (6a, 6b) protrudes.

Fig.1

Fig.2

Fig.3

Fig.4

Fig.5

Fig.6

**European Patent Office**

# EUROPEAN SEARCH REPORT

Application Number

EP 95 11 0234

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | FIFTH EUROPEAN CONFERENCE ON POWER ELECTRONICS AND APPLICATIONS, vol. 3, 13 - 16 September 1993 pages 93-97, PG BARNWELL ET AL. 'Low Profile High Frequency Power Supplies Using Thick Film Planar Transformers' | 1,3,5,6 | H03K17/95 |
| A | * page 93, right column, line 7 - line 17 * <br> * page 95, right column, line 5 - left column, line 2 * <br> * figures 1,2 * | 2 | |
| A | PATENT ABSTRACTS OF JAPAN vol. 009 no. 049 (E-300) ,2 March 1985 & JP-A-59 190719 (TATEISHI DENKI KK) 29 October 1984, * abstract * | 1,5,8 | |
| A | GB-A-2 272 109 (MURATA MANUFACTURING CO) 4 May 1994 * page 3, line 4 - line 19 * <br> * page 4, line 22 - page 5, line 15 * <br> * page 8, line 1 - page 9, line 6 * <br> * figures 3-5 * | 1,2,5,10 | |
| D,A | DE-A-32 44 449 (OMRON TATEISI ELECTRONICS CO) 16 June 1983 * page 7, line 22 - page 8, line 22; figures 3-5 * | 1,6,7 | |
| A | PATENT ABSTRACTS OF JAPAN vol. 940 no. 011 & JP-A-06 325939 (MURATA MFG CO LTD) 25 November 1994, * abstract * | 1,6 | |

TECHNICAL FIELDS SEARCHED (Int.Cl.6)

H03K
H01F

The present search report has been drawn up for all claims

| Place of search | Date of completion of the search | Examiner |
|---|---|---|
| THE HAGUE | 6 November 1995 | D/L PINTA BALLE.., L |

EPO FORM 1503 03.82 (P04C01)